# FASCICULE DE BREVET EUROPEEN

(11) **EP 2 917 789 B1**
(45) Date de publication et mention de la délivrance du brevet: **03.01.2018**
(21) Numéro de dépôt: 13789255.0
(22) Date de dépôt: 06.11.2013
(51) Int. Cl.: G04B 15/14, G04B 17/26, G04B 15/12, C30B 29/18, C30B 1/10

(54) **MÉCANISME À ANCRE POUR ÉCHAPPEMENT D'HORLOGERIE**
PALETTENMECHANISMUS FÜR EINE UHRENHEMMUNG
PALLET MECHANISM FOR A TIMEPIECE ESCAPEMENT

(30) Priorité: 09.11.2012 EP 12192026
(43) Date de publication de la demande: 16.09.2015
(73) Titulaire: Nivarox-FAR S.A., 2400 Le Locle (CH)
(72) Inventeur: STRANCZL, Marc, CH-1260 Nyon (CH); HESSLER, Thierry, CH-2024 St-Aubin (CH)
(74) Mandataire: Giraud, Eric
(86) Numéro de dépôt international: PCT/EP2013/073118
(87) Numéro de publication internationale: WO 2014/072319

(56) Documents cités:
- EP-A2- 2 037 335
- WO-A1-2011/120180
- CH-A2- 703 333

## Description

### Domaine de l'invention

L'invention concerne un mécanisme à ancre pour un mécanisme d'échappement comportant au moins une structure fixe portant un balancier et une roue d'échappement coopérant l'une avec l'autre, ledit mécanisme d'ancre étant agencé pour limiter ou transmettre le débattement angulaire dudit balancier ou/et de ladite roue d'échappement, ladite ancre comportant des palettes de coopération avec ladite roue d'échappement et comportant au moins un élément flexible multistable, où la coopération de ladite ancre avec ledit balancier est effectuée par des cornes d'une première partie de ladite ancre.

L'invention concerne encore un mouvement d'horlogerie comportant au moins un mécanisme d'échappement avec organe régulateur à balancier, et qui comporte au moins un tel mécanisme à ancre.

L'invention concerne encore une pièce d'horlogerie ou montre, comportant au moins un tel mouvement ou au moins un tel mécanisme à ancre.

L'invention concerne le domaine des mécanismes d'échappement d'horlogerie.

### Arrière-plan de l'invention

L'amélioration de la marche et la recherche d'un meilleur rendement sont des préoccupations constantes des constructeurs de montres mécaniques, qui cherchent à obtenir la plus grande réserve de marche possible, conjuguée avec régularité, précision, et sécurité dans les conditions d'utilisation les plus dures.. L'ensemble réglant, et le mécanisme d'échappement sont au coeur de cette problématique.

En particulier, dans les montres mécaniques, les échappements doivent répondre à plusieurs critères dits de sécurité. Une des sécurités, le mécanisme anti-galop, vise à empêcher l'extension angulaire du balancier au-delà d'un angle normal de rotation.

Le brevet EP 1 801 668 B1 au nom de MONTRES BREGUET SA propose un mécanisme dont la structure est caractéristique en ce qu'il comprend un pignon monté sur l'arbre du balancier. Ce pignon engrène une roue dentée dont au moins un rayon vient buter contre un arrêt fixe si le balancier est entrainé au-delà de son angle normal de rotation. Ce mécanisme influence l'inertie du balancier et perturbe ainsi ses oscillations. De plus, l'engrenage qui le compose présente des frottements qui perturbent également le mécanisme de régulation.

Le document EP 1 666 990 A2 au nom de MONTRES BREGUET SA expose un autre mécanisme anti-galop basé sur l'expansion du spiral: un bras de blocage, fixé sur la spire extérieure du spiral, s'interpose entre un doigt solidaire du balancier et deux colonnes solidaires du pont du balancier. Ce blocage a lieu uniquement en cas d'expansion excessive du spiral au-delà d'un angle dépassant son angle de fonctionnement normal. Ce mécanisme limite l'angle de rotation uniquement dans un sens de rotation.

Le document EP 2 450 756 A1 NIVAROX décrit un dispositif anti-galop pour mécanisme d'échappement, avec un mobile pivotant porteur d'un doigt lequel circule dans une piste de came solidaire du balancier. Ce mobile pivotant peut comporter un bras avec une bascule bistable, notamment une lame élastique bistable.

Le document EP 2 037 335 A2 ENZLER-VON GUNTEN décrit une ancre qui comporte deux bras munis de palettes, et une fourchette d'ancre, l'ensemble étant réalisé de façon monobloc avec deux lames flexibles de fixation, qui définissent un axe virtuel de pivotement de l'ancre, et qui autorisent le pivotement de l'ancre lors de leur flexion, les axes médians de ces deux lames se coupant au niveau de cet axe virtuel.

Le document WO2011/120 180 A1 au nom de ROLEX décrit un dispositif de blocage de roue d'échappement avec un bloquer à deux palettes relié par deux éléments élastiques à un châssis pour définir un pivot virtuel, et au moins un troisième élément élastique agissant latéralement sur le bloqueur.

Le document CH 703 333 A2 au nom de FRAGNIERE décrit une ancre avec un ressort de rappel bistable fixé sur la baguette de l'ancre entre la fourchette et l'axe de pivotement.

Le document WO 2013/144236 au nom de NIVAROX décrit un mécanisme d'échappement flexible à cadre mobile porté par des lames flexibles bistables.

Le document EP 2 431 823 A1 au nom de BLANCPAIN décrit un échappement à ancre avec des surfaces antagonistes magnétisées ou électrisées.

Le document FR 2 258 656 A1 au nom de FAR décrit un échappement à ancre avec un encliquetage où des éléments flexibles solidaires de l'ancre sont soumis à un champ magnétique.

En somme, les mécanismes de sécurité connus présentent, chacun, au moins un des inconvénients récurrents : la perturbation des oscillations par modification de l'inertie de l'organe régulateur, la dégradation du rendement sous l'effet de frottement, la limitation de l'angle de rotation dans un sens de rotation seulement.

### Résumé de l'invention

La présente invention vise à améliorer le rendement d'une montre, et à résoudre les problèmes cités plus haut, en ne perturbant que très faiblement les oscillations du balancier, avec une perte de rendement négligeable ou nulle, et en limitant la course angulaire du balancier dans les deux sens de rotation.

Le mécanisme anti-galop selon l'invention se base sur un principe de mémorisation de la position du balancier analogue à celui de l'ancre suisse : un élément change de position au passage du balancier et positionne une butée anti-galop, comme le font, dans le cas de l'ancre suisse, les goupilles de limitation d'entrée et sortie ou étoqueaux via la fourchette et ses cornes.

A cet effet, l'invention concerne un mécanisme à ancre pour un mécanisme d'échappement comportant au moins une structure fixe portant un couple lequel comporte un balancier et une roue d'échappement coopérant l'une avec l'autre, ledit mécanisme d'ancre coopérant avec ledit couple pour limiter ou transmettre le débattement angulaire dudit balancier ou/et de ladite roue d'échappement, ladite ancre comportant des palettes de coopération avec ladite roue d'échappement et comportant au moins un élément flexible multistable, caractérisé en ce que la coopération de ladite ancre avec ledit balancier est effectuée par des cornes d'une première partie de ladite ancre, ladite première partie étant reliée par au moins un dit élément flexible, ou bien à ladite structure fixe, ou bien à une deuxième partie de ladite ancre porteuses desdites palettes de coopération avec ladite roue d'échappement, ladite deuxième partie étant reliée par au moins un dit élément flexible à ladite structure fixe ou à ladite première partie, caractérisé en ce que au moins un dit élément flexible comporte au moins une poutre précontrainte en flambage selon un deuxième mode où ladite poutre adopte une forme en S ou en Z, ledit mécanisme à ancre comportant un pivot obligeant ladite poutre à avoir un noeud en son milieu.

L'invention concerne encore un mouvement d'horlogerie comportant au moins un mécanisme d'échappement avec organe régulateur à balancier, et qui comporte au moins un tel mécanisme à ancre, caractérisé en ce que ledit mouvement comporte une structure, ou bien à laquelle est fixé un dit au moins élément flexible dudit mécanisme à ancre, ou bien qui est constituée par un dit au moins un élément flexible.

L'invention concerne encore une pièce d'horlogerie ou montre, comportant au moins un tel mouvement ou au moins un tel mécanisme à ancre.

### Description sommaire des dessins

D'autres caractéristiques et avantages de l'invention apparaîtront à la lecture de la description détaillée qui va suivre, en référence aux dessins annexés, où :
- la figure 1 représente, de façon schématisée et en vue de face, un mécanisme horloger de limitation ou transmission selon l'invention, réalisé sous la forme d'un mécanisme anti-galop selon l'invention, fixé à une structure d'un mouvement et coopérant alternativement avec l'un de plusieurs bras qu'il comporte, deux dans cette illustration, avec une cheville d'un balancier ;
- la figure 2 représente, de façon similaire à la figure 1, le même mécanisme complété par un mécanisme antichocs ;
- la figure 3 représente, de façon schématisée, trois états d'une poutre encastrée : au repos en figure 3A, dans un premier mode de flambage en forme de « C » en figure3B dans un deuxième mode de flambage en forme de « S » ou de « Z » en figure 3C;
- la figure 4 représente, de façon schématisée et en vue de face, une poutre encastrée précontrainte en flambage dans le deuxième mode de la figure 3C sous l'action d'un pivot flexible ;
- la figure 5 représente, de façon schématisée et en vue de face, une réalisation de l'invention selon le principe de la figure 4, avec une précontrainte par vis excentrées de la poutre en flambage, et dans une exécution monobloc ;
- la figure 6 illustre une variante de la figure 5 et où la précontrainte est réalisée par des poches d'oxyde de silicium dans un bâti en silicium ; les figures 6A et 6B illustrent, avant et après oxydation du silicium, un détail d'une zone comportant de fortes différences de section, et fortement modifiée après formation de dioxyde de silicium, et soumettant à un effort en flambage une poutre droite de section moindre ;
- la figure 7 illustre un autre principe de précontrainte par différentiel de résistance au flambage entre un réseau de poutres parallèles en silicium oxydé et une poutre seule ainsi précontrainte en flambage ; les figures 7A, 7B, 7C, illustrent des étapes successives d'un procédé d'oxydation et de mise en flambage d'une poutre ;
- la figure 8 illustre une variante avec des bras de butée anti-galop comportant des zones flexibles d'amortissement de chocs ;
- la figure 9 représente, de façon schématisée et partielle, une pièce d'horlogerie sous la forme d'une montre comportant un mouvement avec un dispositif anti-galop selon l'invention ;
- la figure 10 illustre une configuration dans laquelle un pivot virtuel bistable du mécanisme anti-galop est mobile en translation ;
- la figure 11 illustre un détail d'un mécanisme anti-galop comportant au moins deux niveaux pour assurer le maintien des bras du système anti-galop dans le plan de la cheville de balancier : un premier niveau supérieur avec des bras coopérant avec cette cheville, et un deuxième niveau inférieur avec un dard coopérant avec une encoche de balancier ;
- la figure 12 est une structure déformable par oxydation du silicium, en variante de celle de la figure 7A ;
- la figure 13 représente la section d'une structure en quartz monocristallin, pour la réalisation d'un mécanisme anti-galop selon l'invention ;
- la figure 14 illustre un mécanisme selon l'invention, avec une fonction de répulsion, entre la cheville de balancier et les bras du mécanisme anti-galop, est remplie par des aimants situés dans une orientation verticale, et avec une coupe selon la ligne en trait interrompu ;
- la figure 15 illustre une réalisation analogue, avec une orientation dans le plan du champ magnétique ;
- la figure 16 schématise, de façon analogue à la figure 10, un cas plus général où le mouvement est quelconque, et bistable ;
- les figures 17A et 17B illustrent l'obtention de la précontrainte par rencontre des croissances d'oxyde (avant et après) dans un serpentin.
- les figures 18A et 18B (et leurs détails en figures 19A et 19B) montrent l'obtention de la précontrainte par l'ouverture des angles au sommet d'un profilé en zig-zag lors de la croissance de l'oxyde de silicium (avant et après) ;
- les figures 20A et 20B illustrent une variation d'angle obtenue par la variation (avant et après) du rayon de courbure des parois oxydées dans une zone à très faible rayon de courbure ;
- la figure 21 montre schématiquement une lame flexible bistable coopérant avec les deux extrémités d'une masse unique ;

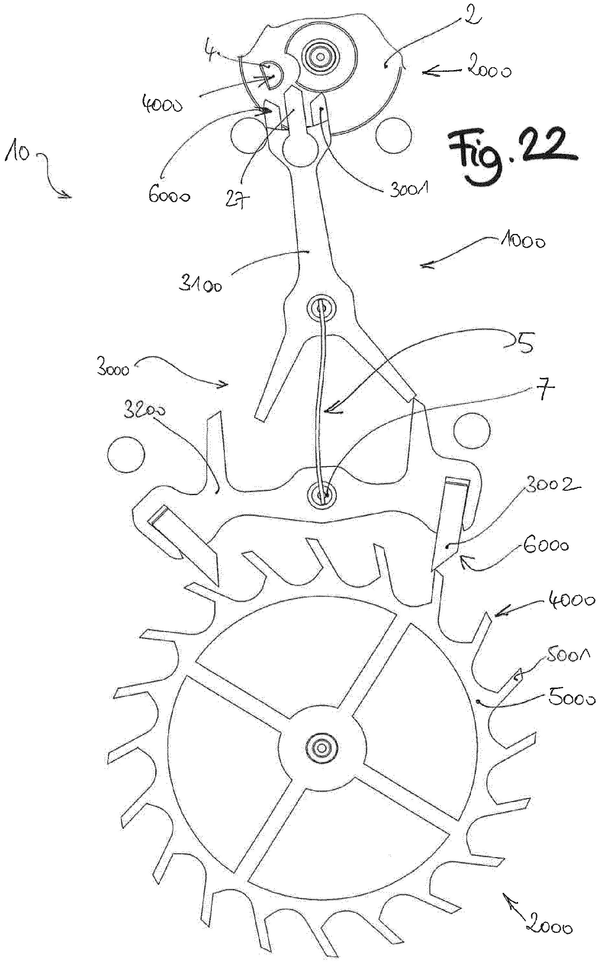

- la figure 22 illustre en vue en plan une autre application où le mécanisme horloger de limitation ou transmission est un mécanisme d'ancre entre un balancier et une roue d'échappement ;
- la figure 23 illustre une variante de la figure 22 où une lame flexible de liaison entre deux parties de l'ancre est pivotée en un point intermédiaire à ses extrémités.

### Description détaillée des modes de réalisation préférés

L'invention concerne un mécanisme horloger de limitation ou transmission 1000 pour limiter ou transmettre le débattement angulaire d'un mobile 2000 d'un mouvement d'horlogerie 10, ce mobile 2000 comportant au moins une cheville ou dent 4000 saillante, notamment radialement dans le cas d'une dent 5001, ou axialement dans le cas d'une cheville 4. Selon l'invention, ce mécanisme horloger de limitation ou transmission 1000 comporte des moyens de limitation ou de transmission 6000 qui sont fixés, par l'intermédiaire au moins un élément flexible multistable, notamment bistable, 5, à un autre composant du mouvement 10 ou à un élément rigide de structure 7 du mouvement 10.

Dans une application particulière, ce mécanisme horloger de limitation ou transmission 1000 est un mécanisme anti-galop 1, qui est destiné à empêcher l'emballement d'un balancier d'horlogerie 2, lequel comporte un arbre 3 et une cheville 4 ou un élément similaire saillant de cet arbre 3.

Selon l'invention, le mécanisme anti-galop 1 comporte au moins un élément monolithique bistable flexible, qu'on dénommera ci-après élément flexible bistable 5, porteur d'au moins une butée anti-galop 6, et qui est fixé, par l'intermédiaire d'éléments de liaison flexibles et élastiques, à un élément rigide de structure 7, tel que platine, pont, ou similaire, d'un mouvement d'horlogerie 10 dans lequel est intégré un organe régulateur auquel appartient le balancier 2.

Dans une variante particulière, cette structure 7 contient un système d'auto-alignement avec l'axe du balancier 2.

Cet élément flexible bistable 5 est porteur d'au moins une butée anti-galop 6, dont une extrémité 63 ou 64 peut, selon la position angulaire du balancier 2, venir en interférence avec la trajectoire de la cheville 4, et remplir la fonction de butée si le balancier 2 dépasse sa course angulaire normale.

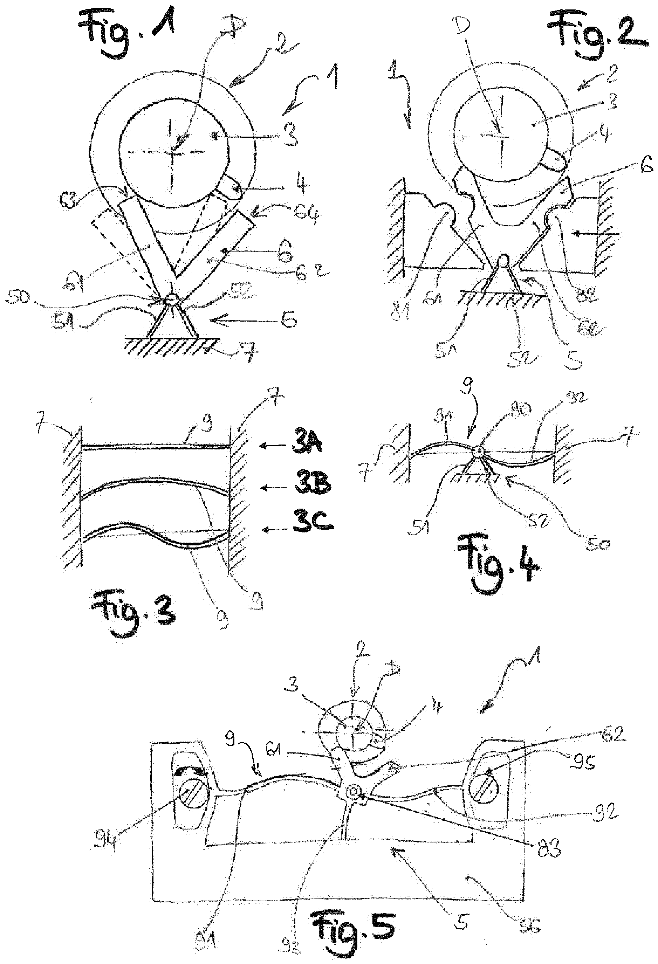

La figure 1 expose le schéma de principe, dans une application particulière, préférée mais non limitative, où l'élément flexible bistable 5 et la au moins une butée anti-galop 6 forment ensemble un composant monolithique. Dans cet exemple nullement limitatif, la butée anti-galop 6 comporte deux bras 61, 62, dont les extrémités respectives 63, 64, peuvent chacune, selon la position du balancier 2, venir en interférence avec la trajectoire de la cheville 4, et remplir la fonction de butée si le balancier 2 dépasse sa course angulaire normale. Cette réalisation à deux bras, telle qu'illustrée, assure la limitation de l'angle de rotation du balancier 2 dans les deux sens de rotation de ce dernier. La figure 1 montre, en trait interrompu, une position d'interférence avec le balancier 2, assurant la limitation de son débattement angulaire.

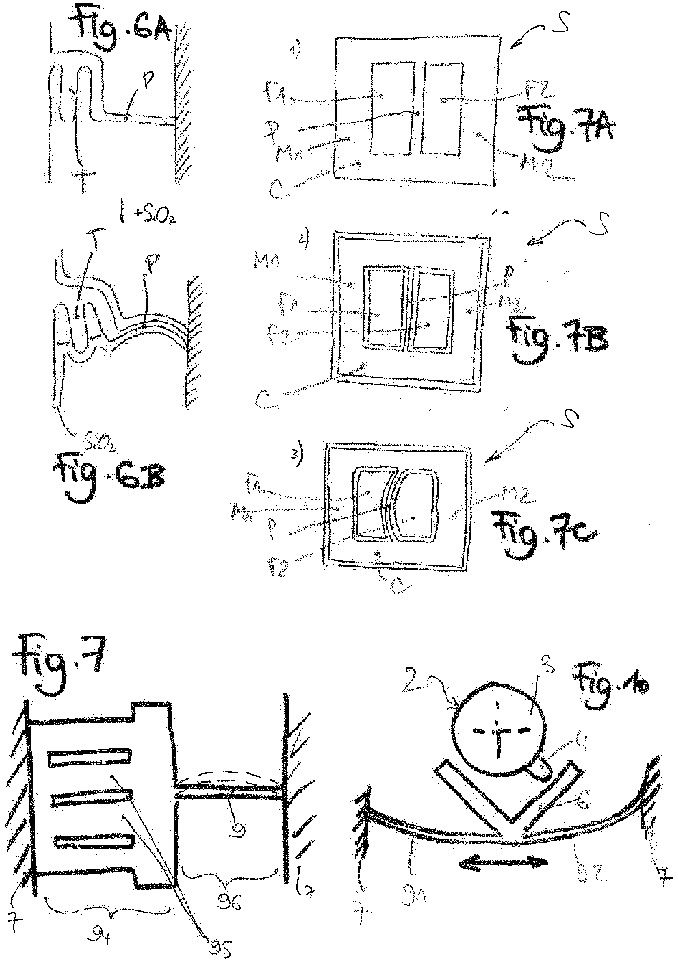

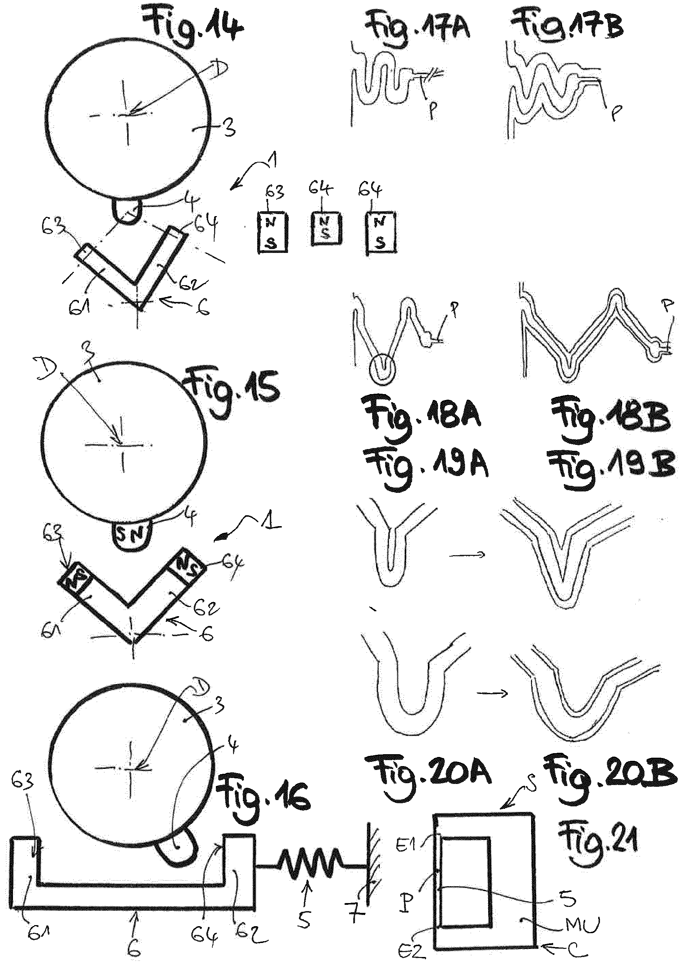

L'élément flexible bistable 5 est ici illustré dans un cas particulier, non limitatif, avec ces éléments de liaison flexibles et élastiques qui sont constitués par au moins deux lames fines 51, 52, chacune fixée à une première extrémité à la structure 7, et reliées par une deuxième extrémité au corps de l'élément flexible. Dans le cas particulier de la figure 1, les deux lames fines 51, 52, sont reliées par leurs deuxièmes extrémités au corps de l'élément flexible en formant un vé, de façon à définir un pivot fictif 50 autour duquel peut pivoter la butée anti-galop 6. Ainsi, dans le cas des figures 1 et 2, l'élément flexible bistable 5 selon l'invention est un pivot flexible bistable. Ce mode de réalisation n'est pas exclusif, la figure 10 schématise le cas où la butée anti-galop 6 est mobile en translation. La figure 16 illustre un cas plus général où le mouvement est quelconque, et bistable.

De préférence, au moins deux éléments flexibles 5, notamment deux lames flexibles 51, 91, 52, 92, sont montés précontraints en flambage par rapport à la structure 7 ou par rapport à un bâti 56 que comporte l'élément flexible bistable 5.

Chacune des éléments flexibles 5 ou des lames 51, 52 peut occuper plusieurs états, selon les efforts auxquels il est soumis ou elle est soumise. Chacune de ces lames est calculée pour travailler en flambage, et peut adopter plusieurs géométries, selon son mode de flambage, tel que visible sur la figure 3 : au repos en figure 3A, en premier mode de flambage, avec une forme concave ou convexe en forme de « C » en figure 3B, en deuxième mode de flambage avec une forme en « S » ou « Z » en figure 3C. L'élément flexible bistable 5 peut comporter des éléments flexibles avec d'autres formes que ces lames flexibles 51, 52, illustrées ici, sans s'éloigner de l'invention.

L'élément flexible bistable 5 peut, encore, dans une réalisation particulière, être réalisé monobloc avec l'élément de structure 7.

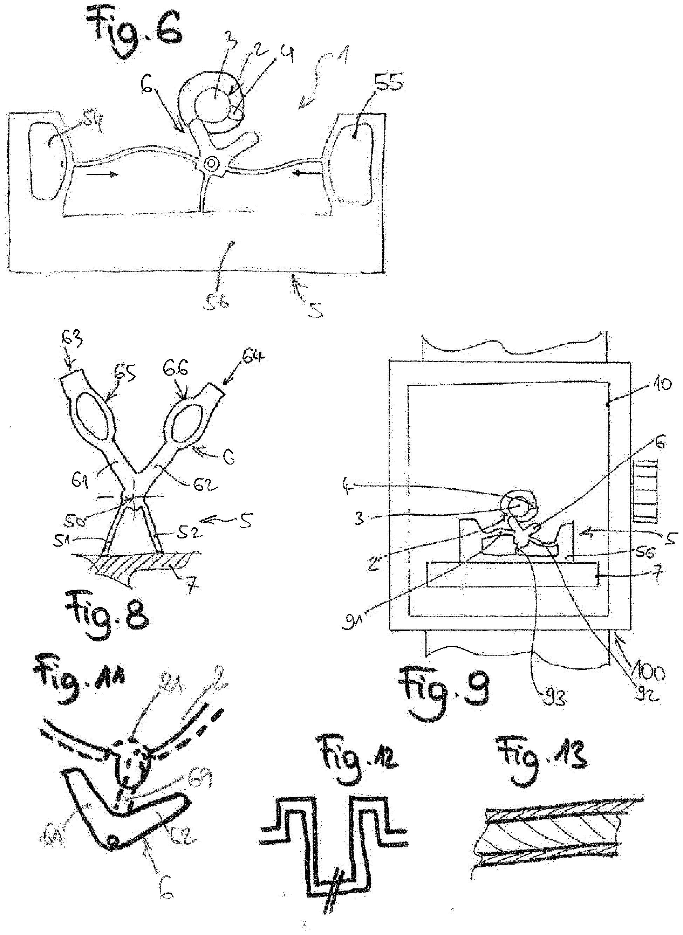

Dans une réalisation particulière, illustrée à la figure 8, des éléments flexibles 65, 66, peuvent être inclus aux bras 61, 62, de la butée 6 du mécanisme anti-galop 1, afin d'éviter des chocs trop importants.

Un tel élément flexible bistable 5 peut être réalisé par technologie silicium, « LIGA », MEMS, ou similaire. Son inertie est très faible comparée à celle du balancier 2, et son actionnement perturbe faiblement les oscillations du balancier 2.

La figure 2 illustre un mécanisme antichoc de protection des lames flexibles 51 et 52 de l'élément flexible bistable 5. Il est utile, voire nécessaire, dans les cas où les butées anti-galop 6 doivent limiter l'amplitude du balancier 2. Le but est d'absorber les chocs dans des butées antichocs 81, 82, qui coopèrent en appui de butée avec les bras 61, 62, et de ne pas transmettre ces chocs dans les lames flexibles 51, 52 afin d'éviter une rupture de celles-ci. La figure 5 présente une butée antichocs 83 coaxiale avec le pivot flexible. Dans cet exemple de réalisation les butées antichocs 81 et 82 comportent des saillantes sensiblement cylindriques, qui coopèrent avec des rainures de forme sensiblement complémentaire sur les bras 61 et 62.

Le pivot bistable flexible 5 peut être réalisé selon plusieurs principes. La figure 3 introduit un principe d'état bistable étudié dans ce cas particulier. On utilise les modes naturels de flambage d'une poutre 9 soumise à une contrainte, plus particulièrement le deuxième mode illustré en 3C.

Selon l'invention, et tel que visible sur la figure 4, afin de contraindre la poutre 9 à flamber selon le deuxième mode, un pivot 90 oblige la poutre 9 à avoir un noeud en son milieu (centre de rotation du pivot ajouté). Par milieu on entend un point intermédiaire entre les extrémités de la poutre 9, et non le strict milieu géométrique qui ne représente qu'une variante particulière. Le centre de rotation 50 du pivot bistable 5 correspond alors au centre de rotation du pivot 90 ajouté.

La figure 5 expose un mécanisme anti-galop 1 complet réalisé selon ce principe. Le pivot bistable flexible 5 comporte au moins une poutre 9 précontrainte en flambage selon un deuxième mode où la poutre 9 adopte une forme en S ou en Z, un pivot 90 obligeant cette poutre 9 à avoir un noeud en zone médiane, de préférence en son milieu. De façon préférée dans le cas de la figure 5, le pivot bistable flexible 5 est réalisé par flambage de deux poutres 91 et 92 précontraintes (qui composent ensemble la poutre 9) en les contraignant ici via deux vis excentrées 94 et 95. Une troisième poutre 93, fixée à la structure 7 ou à un bâti 56 de l'élément flexible bistable 5, force la poutre 9 composée des poutres 91 et 92 à se déformer dans le deuxième mode, et joue le rôle du pivot 90 de la figure 4. La butée antichoc 83 est située dans le centre de rotation 50 du pivot bistable flexible 5.

La figure 11 illustre une butée anti-galop 6 comportant au moins deux niveaux pour assurer le maintien des bras 61, 62, du système anti-galop dans le plan de la cheville 4 de balancier: un premier niveau supérieur avec des bras 61 et 62 coopérant avec cette cheville 4, et un deuxième niveau inférieur avec un dard 67 coopérant avec une encoche 21 du balancier 3.

Pour supprimer les contacts ou du moins diminuer les pressions de contact, le mécanisme anti-galop 1 selon l'invention peut encore avantageusement comporter des moyens pour créer une force ou un couple de répulsion entre le balancier 2 et les bras 61, 62, du mécanisme anti-galop 1.

La figure 14 illustre le cas où cette fonction de répulsion est remplie par des aimants situés dans une orientation verticale, au niveau de la cheville 4 et des extrémités 63, 64, des bras 61, 62. La figure 15 illustre une réalisation analogue, avec une orientation dans le plan du champ magnétique, on voit les pôles nord et sud de ces aimants.

Dans une localisation similaire, on peut avantageusement utiliser, à la place des aimants, ou en plus de ceux-ci, des électrets (charges électrostatiques) pour exercer de telles forces de répulsion.

Il s'agit d'augmenter le rendement du mécanisme anti-galop 1, et de perturber le moins possible la marche du balancier 2. Le fonctionnement du mécanisme anti-galop 1 est le suivant :
- lors du basculement, dans une première phase, le balancier 2 fournit de l'énergie à l'élément flexible bistable 5 ;
- une fois passé le point d'équilibre, dans une deuxième phase, le mécanisme restitue une partie de l'énergie au balancier 2 en faisant une petite impulsion.

Le mécanisme fonctionne de manière analogue aux cornes d'une ancre suisse, il y a un dégagement puis une impulsion.

Dans une réalisation particulière, le balancier 2, ou/et au moins les bras 61, 62, de la butée anti-galop 6, voire le mécanisme anti-galop 1 complet quand il est monobloc, dans une réalisation avantageuse, est réalisé en technologie silicium à partir d'un wafer silicium, avec ou sans croissance d'oxyde de silicium, et avec une couche superficielle renfermant, selon le cas, ou bien des aimants ou des particules magnétiques d'une part, ou bien des électrets d'autre part. Cette couche particulière peut être réalisée par un procédé galvanique, ou par pulvérisation cathodique, ou par un autre procédé microtechnique de structuration adéquat.

Dans le cas préféré d'une élaboration de l'élément flexible bistable 5 en technologie silicium, la création de contraintes dans les lames constituant les poutres 91 et 92 peut se faire par oxydation du silicium. En effet, l'oxyde de silicium prend un plus grand volume lors de sa croissance à partir du silicium, tel que visible sur la figure 6, où des poches 54, 55, de SiO2, sont créées dans un bâti 56 en silicium. On voit sur cet exemple de la figure 5 ou 6, que ce bâti 56 peut aussi constituer la structure 7, ou encore y être relié de façon très simple par toute technologie usuelle de fixation mécanique.

Les figures 6A et 6B illustrent, avant et après oxydation du silicium, un détail d'une zone comportant de fortes différences de section, et fortement modifiée après formation de dioxyde de silicium, et soumettant à un effort en flambage une poutre droite P de section moindre qu'une tête T dont elle constitue un prolongement.

Un autre moyen de réaliser les contraintes de flambage dans ces lames est l'oxydation d'une structure en silicium, de forme particulière, exposée à la figure 7. L'oxydation du silicium induit des contraintes en surface qui ont pour effet d'allonger la longueur d'une poutre oxydée. La figure 7 illustre un autre principe de précontrainte par différentiel de résistance au flambage entre un réseau de poutres parallèles en silicium oxydé et une poutre seule ainsi précontrainte en flambage, et présente un mécanisme simple où, en partie gauche, une structure parallèle 94 comporte un faisceau de poutres parallèles 95 qui vont, après oxydation (en trait interrompu), contraindre en fléchissement en flambage, en partie droite, un élément flexible à contraindre 96, en l'occurrence une poutre 9, 91, 92, ou similaire, dont on désire obtenir une déformation, la résistance au flambage de la structure parallèle 94 étant beaucoup plus grande que celle de l'élément flexible à contraindre 96. Les figures 7A, 7B, 7C, illustrent des étapes successives d'un procédé d'oxydation et de mise en flambage d'une poutre P, ménagée entre deux fenêtres F1, F2 d'un cadre C. La figure 7A montre la structure de base résultant de la mise en forme par gravure du silicium, au moment de sa mise dans un four. La figure 7B illustre le développement d'oxyde de silicium SiO₂, à l'intérieur des fenêtres F1 et F2 et donc sur les flancs de la poutre P, par maintien de la structure à 1100°C pendant plusieurs heures ; de façon connue, la croissance du dioxyde de silicium SiO₂ se fait par consommation partielle du silicium vers l'extérieur du composant, et de ce fait dans la mince poutre P la proportion de dioxyde de silicium SiO₂ augmente quand la proportion de silicium diminue, au fil du temps pendant ce traitement à 1100°C. La figure 7C montre la contraction de la structure après un refroidissement à la température ambiante, environ 20°C : les montants latéraux M1, M2 du cadre C, parallèles à la poutre P, qui sont essentiellement formés de silicium et d'un peu de dioxyde de silicium, se contractent davantage que la poutre P, qui est alors essentiellement formée de dioxyde de silicium qui a un coefficient de dilatation plus faible que le silicium.de ce fait la poutre P est soumise à un effort de flambage, et prend un état bistable.

Une autre variante est illustrée à la figure 12.

Les figures 17A et 17B illustrent aussi l'obtention de la précontrainte par rencontre des croissances d'oxyde dans un serpentin.

Les figures 18A et 18B (et leurs détails en figures 19A et 19B) montrent l'obtention de la précontrainte par l'ouverture des angles au sommet d'un profilé en zig-zag selon le même principe : la croissance de l'oxyde de silicium force l'ouverture de ces angles, et le déplacement est amplifié par la géométrie en Z ou en zig-zag de la structure. Les figures 20A et 20B montrent une variation d'angle obtenue par la variation du rayon de courbure des parois oxydées dans une zone à très faible rayon de courbure.

Ainsi, l'invention concerne également un procédé par lequel on réalise une lame flexible bistable.

Dans une première variante, illustrée par la figure 21, une lame flexible bistable 5 coopère avec les deux extrémités E1, E2, d'au moins une masse, et en particulier d'une masse unique MU. Le procédé comporte alors la succession des opérations suivantes :
- on grave un composant S en silicium dans lequel une poutre longiligne P de faible section fait la liaison entre deux extrémités E1, E2 d'au moins une masse MU, de forte section (au moins supérieure à dix fois cette faible section), cette au moins une masse MU constituant un cadre rigide C ;
- on soumet ce composant S, dans un four, à un procédé connu de croissance de dioxyde de silicium SiO₂ par maintien pendant plusieurs heures à une température de 1100°C ;
- on ajuste cette durée de plusieurs heures de façon à ce que un premier rapport RA entre la section de la poutre P formée de dioxyde de silicium SiO₂ et la section de la poutre P formée de silicium soit supérieur à 1 ; on peut d'ailleurs aller jusqu'à l'oxydation complète du silicium dans cette poutre P qui devient l'élément flexible 5. Un deuxième rapport RB entre la section de la masse MU formée de dioxyde de silicium SiO₂ et la section de la masse MU formée de silicium est très inférieur au premier rapport RA. Le ratio RA/RB est compris entre 2 et 10000, de préférence entre 10 et 1000, et, dans une application préférée, est supérieur à 100.
- on effectue un refroidissement à la température ambiante, environ 20°C, de façon à déformer en flambage la poutre P lors du refroidissement de la au moins une masse MU, dont la contraction lors de ce refroidissement est supérieure à la contraction de cette poutre P. Les figures 7A, 7B, 7C, illustrent une deuxième variante de mise en oeuvre d'un procédé de réalisation d'une lame flexible bistable, impliquant au moins deux masses. Ce procédé comporte la succession des opérations suivantes :
- on grave un composant S en silicium dans lequel une poutre longiligne P de faible section fait la liaison entre au moins deux masses M1, M2, chacune de forte section (au moins supérieure à dix fois cette faible section), ces deux masses M1, M2,constituant ensemble ou avec d'autres éléments de structure un cadre rigide C ;
- on soumet ce composant S, dans un four, à un procédé connu de croissance de dioxyde de silicium SiO₂ par maintien pendant plusieurs heures à une température de 1100°C ;
- on ajuste cette durée de plusieurs heures de façon à ce que le premier rapport RA entre la section de la poutre P formée de dioxyde de silicium SiO₂ et la section de la poutre P formée de silicium soit supérieur à 1 ; on peut d'ailleurs aller jusqu'à l'oxydation complète du silicium dans cette poutre P qui devient l'élément flexible 5. Un deuxième rapport RB entre la section de chacune des masses M1, M2, formée de dioxyde de silicium SiO₂ et la section de la masse correspondante formée de silicium est très inférieur au premier rapport RA. Le ratio RA/RB est compris entre 2 et 10000, de préférence entre 10 et 1000, et, dans une application préférée, est supérieur à 100.
- on effectue un refroidissement à la température ambiante, environ 20°C, de façon à déformer en flambage la poutre P lors du refroidissement des deux masses M1 et M2 dont la contraction lors de ce refroidissement est supérieure à la contraction de cette poutre P.

Dans une autre variante de réalisation, la structure du mécanisme anti-galop 1 est réalisée en quartz monocristallin. Tel que visible sur la figure 13, le noyau central en quartz monocristallin est revêtu sur ses faces supérieure et inférieure d'un dépôt réalisé à une température supérieure à la température ambiante, avec un coefficient α inférieur au coefficient α_{x,y} du quartz. Ce coefficient α_{x,y} du quartz est de 7,5 ppm/°C.

Le mécanisme anti-galop 1 illustré ici limite le sens de rotation du balancier dans les deux sens de rotation. Il ne perturbe que très faiblement les oscillations du balancier 2.

L'invention peut être utilisée dans les montres mécaniques ne présentant pas de mécanisme anti-galop.

Dans une autre application particulière, ce mécanisme horloger de limitation ou transmission 1000 est un mécanisme d'ancre 3000 pour mécanisme d'échappement, notamment mais non limitativement une ancre suisse, sur le même principe, pour sa coopération avec un balancier 2 et avec une roue d'échappement 5000. Une telle ancre 3000, comportant des palettes 3002 de coopération avec les dents 5001 de la roue d'échappement 5000, comporte au moins un élément flexible 5 multistable, notamment bistable. Elle peut être réalisée selon une exécution d'ancre flexible à force constante selon la demande EP2706416 du même déposant. La coopération de cette ancre 3000 avec le balancier 2 est effectuée par des cornes 3001 analogues aux extrémités 63, 64, des bras 61 et 62 de la butée anti-galop 6 décrite ci-dessus, ces cornes 3001 sont portées par une première partie 3100 de l'ancre 3000. Cette première partie 3100 est reliée par au moins un élément flexible 5, notamment une lame flexible 5 multistable, notamment bistable, soit à une structure fixe 7, soit de préférence à une deuxième partie 3200 de l'ancre qui est porteuse de ces palettes 3002 de coopération avec les dents 5001 de la roue d'échappement 5000. De la même façon, ces palettes 3002 sont avantageusement construites de façon analogue à ces bras 61 et 62, et sont reliées par au moins un élément flexible 5, notamment une lame flexible 5 multistable, notamment bistable, soit à une structure fixe 7, soit de préférence à la première partie 3100 de l'ancre comportant les cornes 3001. Dans cette variante la première partie 3100 et la deuxième partie 3200 ont chacune un mouvement propre, leur liaison cinématique étant avantageusement limitée à un ou plusieurs éléments flexibles 5.

De façon particulièrement avantageuse, pour améliorer la marche et le rendement, l'interaction entre les cornes 3001 et le balancier 2 d'une part, ou/et entre les palettes 3002 et la roue d'échappement 5000 d'autre part, est réalisée sans contact ou avec un contact atténué, et, à cet effet, les surfaces concernées des cornes 3001 ou/et des palettes 3002 sont magnétisées ou électrisées pour coopérer en répulsion avec des surfaces antagonistes du balancier ou/et respectivement de la roue d'échappement, qui sont en matériau adéquat, ou/et avantageusement magnétisées ou respectivement électrisées de façon complémentaire. La demande WO2012013374 au nom de SWATCH GROUP RESEARCH AND DEVELOPMENT LTD décrit une telle transmission sans contact ou à contact atténué, dont la combinaison avec un tel mécanisme flexible à lame multistable, notamment une ancre, apporte les avantages recherchés.

Tout particulièrement, ce mécanisme à ancre 3000 est prévu pour un mécanisme d'échappement 7000 qui comporte au moins une structure fixe 7 portant un couple 7100, lequel couple 7100 comporte un balancier 2 et une roue d'échappement 5000 coopérant l'une avec l'autre. Le mécanisme d'ancre 3000 coopère avec ce couple 7100 pour limiter ou transmettre le débattement angulaire du balancier 2 ou/et de la roue d'échappement 5000.

Selon l'invention, cette ancre 3000 comporte au moins un élément flexible 5 multistable. La coopération de l'ancre 3000 avec le balancier 2 est effectuée par des cornes 3001 d'une première partie 3100 de l'ancre 3000. La première partie 3100 est reliée par un tel élément flexible 5 à la structure fixe 7 ou à une deuxième partie 3200 de l'ancre 3000 comportant des palettes 3002 de coopération avec la roue d'échappement 5000. La deuxième partie 3200 est reliée par un tel élément flexible 5, qui peut être le même que celui de la première partie 3100, ou bien un autre élément flexible) à la structure fixe 7 ou à la première partie 3100.

De façon avantageuse dans une version particulière, l'interaction entre les cornes 3001 et le balancier 2 d'une part, ou/et entre les palettes 3002 et la roue d'échappement 5000 d'autre part, est réalisée sans contact ou avec un contact atténué. Et, dans une variante avantageuse, des premières surfaces des cornes 3001 ou/et des palettes 3002 sont magnétisées ou électrisées pour coopérer en répulsion avec des deuxièmes surfaces antagonistes du balancier 2 ou/et respectivement de la roue d'échappement 5000, qui sont en matériau adéquat, ou/et magnétisées ou respectivement électrisées de façon complémentaire.

Dans une variante particulière, l'interaction entre les cornes 3001 et le balancier 2 d'une part, ou/et entre les palettes 3002 et la roue d'échappement 5000 d'autre part, est réalisée sans contact.

Dans une variante particulière, les premières surfaces des cornes 3001 ou/et des palettes 3002 sont magnétisées pour coopérer en répulsion avec des deuxièmes surfaces antagonistes du balancier 2 ou/et respectivement de la roue d'échappement 5000, qui sont magnétisées de façon complémentaire.

Dans une variante particulière, les premières surfaces des cornes 3001 ou/et des palettes 3002 sont électrisées pour coopérer en répulsion avec les deuxièmes surfaces antagonistes du balancier 2 ou/et respectivement de la roue d'échappement 5000, qui sont électrisées de façon complémentaire.

Dans une variante particulière, au moins un tel élément flexible 5 multistable est monté précontraint en flambage par rapport à la structure 7.

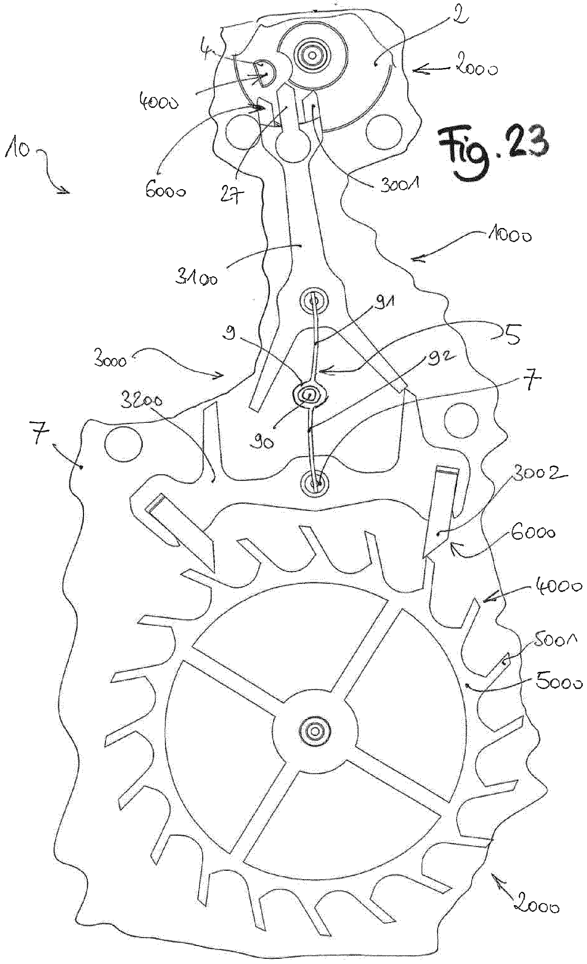

Selon l'invention, au moins un tel élément flexible 5 comporte au moins une poutre 9 précontrainte en flambage selon un deuxième mode où cette poutre 9 adopte une forme en S ou en Z, le mécanisme à ancre 3000 comportant alors un pivot 90 obligeant la poutre 9 à avoir un noeud en son milieu, tel que visible sur la figure 23.

Dans une variante particulière, au moins un élément flexible 5 comporte deux poutres 91, 92, précontraintes en flambage. Et une troisième poutre 93 fixée à la structure 7 force la poutre 9 composée de ces deux poutres 91, 92 à se déformer dans ce deuxième mode, et cette troisième poutre 93 constitue ce pivot 90.

Dans une variante particulière, au moins un tel élément flexible 5 est en silicium, et comporte un bâti 56 comportant des poches 54, 55, d'oxyde de silicium SiO₂ qui assurent la précontrainte de ces deux poutres 91, 92.

Dans une variante particulière, au moins un tel élément flexible 5 comporte au moins une poutre 9, 91, 92, précontrainte en flambage selon un deuxième mode où cette poutre 9, 91, 92, adopte une forme en S ou en Z. Et cet élément flexible bistable 5 est en silicium, et comporte une structure parallèle 94 comportant un faisceau de poutres parallèles 95 qui sont oxydées (c'est-à-dire qui ont subi un gonflement du fait de l'oxydation du silicium) et assurent le fléchissement en flambage d'un élément flexible à contraindre 96 constitué par au moins une telle poutre 9, 91, 92, la résistance au flambage de cette structure parallèle 94 étant beaucoup plus grande que celle de l'élément flexible à contraindre 96.

Dans une variante particulière, au moins un tel élément flexible 5 est réalisé monobloc avec l'élément de structure 7.

Dans une variante particulière, au moins un tel élément flexible 5 est une lame flexible

Dans une variante particulière, la structure de la première partie 3100 ou/et de la deuxième partie 3200 de l'ancre 3000 comporte un noyau central en quartz monocristallin, qui est revêtu sur ses faces supérieure et inférieure d'un dépôt avec un coefficient α inférieur au coefficient α_{x,y} du quartz, lequel est de 7,5 ppm/°C.

L'invention concerne encore un mouvement d'horlogerie 10 comportant au moins un organe régulateur à balancier 2, et qui comporte au moins un mécanisme horloger de limitation ou transmission 1000 selon l'invention, notamment un tel mécanisme à ancre 3000. Selon le cas, ou bien le mouvement 10 comporte une structure 7 à laquelle est fixé un élément flexible bistable 5 de ce mécanisme horloger de limitation ou transmission 1000, ou bien cet élément flexible bistable 5 constitue lui-même une telle structure 7

L'invention concerne encore une pièce d'horlogerie 100, notamment une montre, comportant au moins un tel mouvement 10 ou au moins un tel mécanisme horloger de limitation ou transmission 1000, notamment un tel mécanisme à ancre 3000.

Des mécanismes équivalents basés sur des pivots classiques et des ressorts correspondant aux pivots flexibles et bistables sont considérés comme faisant partie de la présente invention.

Les technologies utilisées pour la réalisation du dispositif ne se limitent pas à la technologie silicium mais également aux procédés « LIGA », « DRIE », « MEMS », et autres procédés de micro-fabrication.

## Revendications

1. Mécanisme à ancre (3000) pour un mécanisme d'échappement (7000) comportant au moins une structure fixe (7) portant un balancier (2) et une roue d'échappement (5000) coopérant l'une avec l'autre, ledit mécanisme d'ancre (3000) étant agencé pour limiter ou transmettre le débattement angulaire dudit balancier (2) ou/et de ladite roue d'échappement (5000), ladite ancre (3000) comportant des palettes (3002) de coopération avec ladite roue d'échappement (5000) et au moins un élément flexible (5) multistable, où la coopération de ladite ancre (3000) avec ledit balancier (2) est effectuée par des cornes (3001) d'une première partie (3100) de ladite ancre (3000), **caractérisé en ce que** ladite première partie (3100) est reliée par au moins un dit élément flexible (5) multistable à une deuxième partie (3200) de ladite ancre (3000) porteuse desdites palettes (3002), le dit élément flexible (5) multistable comportant au moins une poutre (9) précontrainte en flambage selon un mode où ladite poutre (9) adopte une forme en S ou en Z, ledit mécanisme à ancre (3000) comportant un pivot (90) obligeant ladite poutre (9) à avoir un noeud en son milieu.

2. Mécanisme à ancre (3000) selon la revendication 1, **caractérisé en ce que** l'interaction entre lesdites cornes (3001) et ledit balancier (2) d'une part, ou/et entre lesdites palettes (3002) et ladite roue d'échappement (5000) d'autre part, est réalisée sans contact ou avec un contact atténué, et, **en ce que** des premières surfaces desdites cornes (3001) ou/et desdites palettes (3002) sont magnétisées ou électrisées pour coopérer en répulsion avec des deuxièmes surfaces antagonistes dudit balancier (2) ou/et respectivement de ladite roue d'échappement (5000), qui sont en matériau adéquat, ou/et magnétisées ou respectivement électrisées de façon complémentaire.

3. Mécanisme à ancre (3000) selon la revendication 2, **caractérisé en ce que** l'interaction entre lesdites cornes (3001) et ledit balancier (2) d'une part, ou/et entre lesdites palettes (3002) et ladite roue d'échappement (5000) d'autre part, est réalisée sans contact.

4. Mécanisme à ancre (3000) selon la revendication 2 ou 3, **caractérisé en ce que** lesdites premières surfaces desdites cornes (3001) ou/et desdites palettes (3002) sont magnétisées pour coopérer en répulsion avec des deuxièmes surfaces antagonistes dudit balancier (2) ou/et respectivement de ladite roue d'échappement (5000), qui sont magnétisées de façon complémentaire.

5. Mécanisme à ancre (3000) selon l'une des revendications 2 à 4, **caractérisé en ce que** lesdites premières surfaces desdites cornes (3001) ou/et desdites palettes (3002) sont électrisées pour coopérer en répulsion avec lesdites deuxièmes surfaces antagonistes dudit balancier (2) ou/et respectivement de ladite roue d'échappement (5000), qui sont électrisées de façon complémentaire.

6. Mécanisme à ancre (3000) selon l'une des revendications précédentes, **caractérisé en ce que** au moins un dit élément flexible (5) multistable est monté précontraint en flambage par rapport à ladite structure (7).

7. Mécanisme à ancre (3000) selon l'une des revendications précédentes, **caractérisé en ce qu'**au moins un dit élément flexible (5) comporte deux poutres (91, 92) précontraintes en flambage, et une troisième poutre (93) fixée à ladite structure (7) force ladite poutre (9) composée desdites deux poutres (91, 92) à se déformer dans ledit deuxième mode, et **en ce que** ladite troisième poutre (93) constitue ledit pivot (90).

8. Mécanisme à ancre (3000) selon la revendication précédente, **caractérisé en ce que** ledit au moins un élément flexible (5) est en silicium, et comporte un bâti (56) comportant des poches (54, 55), d'oxyde de silicium SiO₂ qui assurent la précontrainte desdites deux poutres (91, 92).

9. Mécanisme à ancre (3000) selon l'une des revendications précédentes, **caractérisé en ce que** ledit élément flexible bistable (5) est en silicium, et comporte une structure parallèle (94) comportant un faisceau de poutres parallèles (95) qui sont oxydées et assurent le fléchissement en flambage d'un élément flexible à contraindre (96) constitué par au moins une dite poutre (9, 91, 92), la résistance au flambage de ladite structure parallèle (94) étant beaucoup plus grande que celle dudit élément flexible à contraindre (96).

10. Mécanisme à ancre (3000) selon l'une des revendications précédentes, **caractérisé en ce que** ledit au moins un élément flexible (5) est réalisé monobloc avec ledit élément de structure (7).

11. Mécanisme à ancre (3000) selon l'une des revendications précédentes, **caractérisé en ce que** au moins un dit élément flexible (5) est une lame flexible

12. Mécanisme à ancre (3000) selon l'une des revendications précédentes, **caractérisé en ce que** la structure de ladite première partie (3100) ou/et de ladite deuxième partie (3200) de ladite ancre (3000) comporte un noyau central en quartz monocristallin, qui est revêtu sur ses faces supérieure et inférieure d'un dépôt avec un coefficient α inférieur au coefficient α_{x,y} du quartz, lequel est de 7,5 ppm/°C.

13. Mécanisme à ancre (3000) selon la revendication 1, **caractérisé en ce que** ledit élément flexible (5) comporte une seule poutre (9).

14. Mouvement d'horlogerie (10) comportant au moins un mécanisme d'échappement (7000) avec organe régulateur à balancier (2), et qui comporte au moins un mécanisme à ancre (3000) selon l'une des revendications précédentes, et **caractérisé en ce que** ledit mouvement (10) comporte ladite structure (7), ou bien à laquelle est fixé un dit au moins élément flexible (5) dudit mécanisme à ancre (3000), ou bien qui est constituée par un dit au moins un élément flexible (5).

15. Pièce d'horlogerie (100) ou montre, comportant au moins un mouvement (10) selon la revendication précédente.

## Patentansprüche

1. Ankermechanismus (3000) für einen Hemmungsmechanismus (7000), umfassend mindestens eine feste Struktur (7), die eine Unruh (2) und ein Hemmungsrad (5000), die miteinander zusammenwirken, trägt, wobei der Ankermechanismus (3000) dafür ausgelegt ist, den Winkelausschlag der Unruh (2) und/oder des Hemmungsrades (5000) zu begrenzen oder zu übertragen, und der Anker (3000) Paletten (3002) für die Zusammenwirkung mit dem Hemmungsrad (5000) und mindestens ein multistabiles biegsames Element (5) aufweist, wobei die Zusammenwirkung des Ankers (3000) mit der Unruh (2) über Hörner (3001) eines ersten Teils (3100) des Ankers (3000) erfolgt, **dadurch gekennzeichnet, dass** der erste Teil (3100) über mindestens ein multistabiles biegsames Element (5) mit einem zweiten Teil (3200) des Ankers (3000) verbunden ist, das die Paletten (3002) trägt, wobei das multistabile biegsame Element (5) mindestens einen Träger (9) aufweist, der gemäß einem Modus, in dem der Träger (9) eine S- oder Z-Form annimmt, knickbelastet ist, wobei der Ankermechanismus (3000) einen Drehzapfen (90) aufweist, der den Träger (9) dazu zwingt, in seiner Mitte einen Knoten aufzuweisen.

2. Ankermechanismus (3000) nach Anspruch 1, **dadurch gekennzeichnet, dass** die Wechselwirkung zwischen den Hörnern (3001) und der Unruh (2) einerseits und/oder zwischen den Paletten (3002) und dem Hemmungsrad (5000) andererseits kontaktlos oder mit gedämpften Kontakt erfolgt und dass erste Oberflächen der Hörner (3001) und/oder der Paletten (3002) magnetisiert oder elektrisch geladen sind, um mit zweiten entgegengesetzten Oberflächen der Unruh (2) und/oder entsprechend des Hemmungsrades (5000), die aus einem zweckmäßigen Material bestehen und/oder auf komplementäre Weise magnetisiert oder entsprechend elektrisch geladen sind, abstoßend zusammenzuwirken.

3. Ankermechanismus (3000) nach Anspruch 2, **dadurch gekennzeichnet, dass** die Wechselwirkung zwischen den Hörnern (3001) und der Unruh (2) einerseits und/oder zwischen den Paletten (3002) und dem Hemmungsrad (5000) andererseits kontaktlos erfolgt.

4. Ankermechanismus (3000) nach Anspruch 2 oder 3, **dadurch gekennzeichnet, dass** die ersten Oberflächen der Hörner (3001) und/oder der Paletten (3002) magnetisiert sind, um mit entgegengesetzten zweiten Oberflächen der Unruh (2) und/oder entsprechend des Hemmungsrades (5000), die auf komplementäre Weise magnetisiert sind, abstoßend zusammenzuwirken.

5. Ankermechanismus (3000) nach einem der Ansprüche 2 bis 4, **dadurch gekennzeichnet, dass** die ersten Oberflächen der Hörner (3001) und/oder der Paletten (3002) elektrisch geladen sind, um mit den entgegengesetzten zweiten Oberflächen der Unruh (2) und/oder entsprechend des Hemmungsrades (5000), die auf komplementäre Weise elektrisch geladen sind, abstoßend zusammenzuwirken.

6. Ankermechanismus (3000) nach einem der vorhergehenden Ansprüche, **dadurch gekennzeichnet, dass** mindestens ein multistabiles biegsames Element (5) in Bezug auf die Struktur (7) knickbelastet montiert ist.

7. Ankermechanismus (3000) nach einem der vorhergehenden Ansprüche, **dadurch gekennzeichnet, dass** mindestens ein biegsames Element (5) zwei knickbelastete Träger (91, 92) umfasst und ein dritter Träger (93), der an der Struktur (7) befestigt ist, den aus den beiden Trägern (91, 92) zusammengesetzten Träger (9) zwingt, sich in dem zweiten Modus zu verformen, und dass der dritte Träger (93) den Drehzapfen (90) bildet.

8. Ankermechanismus (3000) nach dem vorhergehenden Anspruch, **dadurch gekennzeichnet, dass** das mindestens eine biegsame Element (5) aus Silicium ist und einen Rahmen (56) umfasst, der Taschen (54, 55) aus Siliciumoxid (SiO₂) aufweist, die die Vorspannung der beiden Träger (91, 92) sicherstellen.

9. Ankermechanismus (3000) nach einem der vorhergehenden Ansprüche, **dadurch gekennzeichnet, dass** das bistabile biegsame Element (5) aus Silicium ist und eine parallele Struktur (94) aufweist, die ein Bündel paralleler Träger (95) enthält, die oxidiert sind und die Knickbiegung eines vorzuspannenden biegsamen Elements (96) sicherstellen, das aus mindestens einem Träger (9, 91, 92) gebildet ist, wobei der Knickwiderstand der parallelen Struktur (94) sehr viel größer als jener des vorzuspannenden biegsamen Elements (96) ist.

10. Ankermechanismus (3000) nach einem der vorhergehenden Ansprüche, **dadurch gekennzeichnet, dass** das mindestens eine biegsame Element (5) einteilig mit dem Strukturelement (7) hergestellt ist.

11. Ankermechanismus (3000) nach einem der vorhergehenden Ansprüche, **dadurch gekennzeichnet, dass** mindestens ein biegsames Element (5) ein biegsames Plättchen ist.

12. Ankermechanismus (3000) nach einem der vorhergehenden Ansprüche, **dadurch gekennzeichnet, dass** die Struktur des ersten Teils (3100) und/oder des zweiten Teils (3200) des Ankers (3000) einen mittleren Kern aus monokristallinem Quarz aufweist, der an seiner oberen und seiner unteren Fläche mit einer Ablagerung beschichtet ist, deren Koeffizient α kleiner als der Koeffizient α_{x,y} von Quarz ist, der 7,5 ppm/°C beträgt.

13. Ankermechanismus (3000) nach Anspruch 1, **dadurch gekennzeichnet, dass** das biegsame Element (5) einen einzigen Träger (9) umfasst.

14. Uhrwerk (10), das mindestens einen Hemmungsmechanismus (7000) mit einem Unruh-Reglerorgan (2) umfasst und mindestens einen Ankermechanismus (3000) nach einem der vorhergehenden Ansprüche umfasst und **dadurch gekennzeichnet ist, dass** das Werk (10) die Struktur (7) umfasst, an der entweder mindestens ein biegsames Element (5) des Ankermechanismus (3000) befestigt ist oder die durch mindestens ein biegsames Element (5) gebildet ist.

15. Zeitmessgerät (100) oder Uhr, umfassend mindestens ein Werk (10) nach dem vorhergehenden Anspruch.

## Claims

1. Pallet lever mechanism (3000) for an escapement mechanism (7000) including at least one fixed structure (7) carrying a balance (2) and an escape wheel (5000) cooperating with each other, said pallet lever mechanism (3000) being arranged to limit or to transmit the angular travel of said balance (2) and/or of said escape wheel (5000), said pallet lever (3000) including pallet stones (3002) cooperating with said escape wheel (5000), and at least one flexible, multistable element (5), where the cooperation of said pallet lever (3000) with said balance (2) is achieved by means of horns (3001) of a first portion (3100) of said pallet lever (3000), **characterized in that** said first portion (3100) is connected by at least one said flexible element (5) to a second portion (3200) of said pallet lever (3000) carrying said pallet stones (3002), said flexible element (5) including at least one prestressed beam (9) buckled in a mode wherein said beam (9) adopts an S or Z shape, said pallet lever mechanism (3000) including a pivot (90) forcing said beam (9) to have a node at the middle thereof.

2. Pallet lever mechanism (3000) according to claim 1, **characterized in that** the interaction between said horns (3001) and said balance (2) on the one hand, and/or said pallet stones (3002) and said escape wheel (5000) on the other hand, is achieved with no contact or with attenuated contact, and **in that** first surfaces of said horns (3001) and/or of said pallet stones (3002) are magnetised or electrized to cooperate in repulsion with opposing second surfaces of said balance (2) and/or respectively of said escape wheel (5000), which are made of suitable material and/or are magnetised or respectively electrized in a complementary manner.

3. Pallet lever mechanism (3000) according to claim 2, **characterized in that** the interaction between said horns (3001) and said balance (2) on the one hand, and/or between said pallet stones (3002) and said escape wheel (5000) on the other hand, is achieved with no contact.

4. Pallet lever mechanism (3000) according to claim 2 or 3, **characterized in that** said first surfaces of said horns (3001) and/or of said pallet stones (3002) are magnetised to cooperate in repulsion with second opposing surfaces of said balance (2) and/or respectively of said escape wheel (5000), which are magnetised in a complementary manner.

5. Pallet lever mechanism (3000) according to any of claims 2 to 4, **characterized in that** said first surfaces of said horns (3001) and/or of said pallet stones (3002) are electrized to cooperate in repulsion with said second opposing surfaces of said balance (2) and/or respectively of said escape wheel (5000), which are electrized in a complementary manner.

6. Pallet lever mechanism (3000) according to any of the preceding claims, **characterized in that** at least one said flexible, multistable element (5) is mounted prestressed and buckled in relation to said structure (7).

7. Pallet lever mechanism (3000) according to any of the preceding claims, **characterized in that** at least one said flexible element (5) includes two prestressed buckled beams (91, 92), and a third beam (93) fixed to said structure (7) forces said beam (9) formed of said two beams (91, 92) to deform in said second mode, and **in that** said third beam (93) forms said pivot (90).

8. Pallet lever mechanism (3000) according to the preceding claim, **characterized in that** said at least one flexible element (5) is made of silicon, and includes a frame (56) including pouches (54, 55) of silicon oxide SiO₂ which prestress said two beams (91, 92).

9. Pallet lever mechanism (3000) according to any of the preceding claims, **characterized in that** said flexible, bistable element (5) is made of silicon, and includes a parallel structure (94) including a set of parallel beams (95) which are oxidised and ensure the bending and buckling of a flexible element to be prestressed (96) formed by at least one said beam (9, 91, 92), the buckling resistance of said parallel structure (94) being much greater than that of said flexible element (96) to be prestressed.

10. Pallet lever mechanism (3000) according to any of the preceding claims, **characterized in that** said at least one flexible element (5) is made in a single piece with said structural element (7).

11. Pallet lever structure (3000) according to any of the preceding claims, **characterized in that** at least one said flexible element (5) is a flexible strip.

12. Pallet lever mechanism (3000) according to any of the preceding claims, **characterized in that** the structure of said first portion (3100) and/or of said second portion (3200) of said pallet lever (3000) includes a central single crystal quartz core, which is coated on the upper and lower surfaces thereof with a deposition having a coefficient α lower than the coefficient α_{x,y} of quartz, which is 7.5 ppm/°C.

13. Pallet lever mechanism (3000) according to claim 1, **characterized in that** said single flexible element (5) includes a single beam (9).

14. Timepiece movement (10) including at least one escapement mechanism (7000) with a regulating member having a balance (2), and which includes at least one pallet lever mechanism (3000) according to any of the preceding claims, and **characterized in that** said movement (10) includes said structure (7), which is either fixed to one said at least one flexible element (5) of said pallet lever mechanism (3000), or which is formed by one said at least one flexible element (5).

15. Timepiece (100) or watch including at least one movement (10) according to the preceding claim.
